# EUROPEAN PATENT APPLICATION

(11) **EP 2 221 825 A1**
(43) Date of publication of application: **25.08.2010**
(21) Application number: 09305108.4
(22) Date of filing: 05.02.2009
(51) Int. Cl.: G11C 7/24, G11C 16/22

(54) **Non-volatile storage device with forgery-proof permanent storage option**

(71) Applicant: Thomson Licensing, 92130 Issy-les-Moulineaux (FR)
(72) Inventor: Klausberger, Wolfgang, 30519, Hannover (DE); Blawat, Meinolf, 30659, Hannover (DE); Jachalsky, Jörn, 30173, Hannover (DE); Schuetze, Herbert, 29227, Celle (DE)
(74) Representative: Rittner, Karsten

(57) **Abstract**

The invention is related to non-volatile storage devices. More precisely, the invention is related to non-volatile storage devices allowing for storing of data and for altering of already stored data.

The invention proposes a non-volatile storage device comprising a storage unit (FM), means for receiving an access change indication (CON) and means for changing access to said storage unit (WP) in response to said access change indication wherein access prior to reception of said access change indication is such that data can be stored in said storage unit (FM) and already stored data can be altered and access after said access change is such that said at least some of already stored data is unalterable.

This makes use of non-volatile storage devices even more flexible as it combines the advantages of permanent, fogery-proof storage with the advantages of erasable storage.

## Description

### Background

The invention is related to non-volatile storage devices. More precisely, the invention is related to non-volatile storage devices allowing for storing of data and for altering of already stored data.

Examples of such non-volatile storage devices are electrically erasable programmable Read-Only Memories (EEPROM) like flash, ferroelectric random access memories (FeRAM), magneto-resistive random access memories (MRAM) or phase-change memory (PRAM).

Such non-volatile storage devices are comprised in electronic consumer devices such as digital still cameras, digital video cameras, mp3-players, mobile phones, Dictaphones and the like.

These storage devices allow for power-supply independent storage of data and thus very flexible use of the consumer electronic devices or sensing devices. For instance, a user may make photographs or video clips during the day and review or post-process the shots in the evening. Worthless shots can be discarded and quality of other shots can be increased, e.g. by filtering the shot.

### Invention

While for most application in which such storage devices are used the possibility to change data stored is a crucial feature for wide-spread use, there are applications in which non-alterable and permanent storage is desirable. For instance, after a car accident those involved in the accident would like to take pictures for documenting the position of the cars and/or the damages caused by the accident for further use in settling responsibility or insurance claims. But, if such pictures are stored in a way in which they may be manipulated in any way, the pictures are worthless.

Therefore, a non-volatile storage device according to claim 1 is proposed.

Said non-volatile storage device comprises a storage unit, means for receiving an access change indication and means for changing access to said storage unit in response to said access change indication wherein access prior to access change is such that data can be stored in said storage unit and already stored data can be altered and access after said access change is such that said at least some of already stored data is unalterable.

This makes use of non-volatile storage devices even more flexible as it combines the advantages of permanent, forgery-proof storage with the advantages of erasable storage.

In an embodiment, said storage device may further comprise means for write controlling which generate a deactivation voltage and/or a deactivation current in response to said access change indication.

Said deactivation voltage and/or a deactivation current may be generated immediately after receiving said access change indication. Or, some delay may be realized between reception of said access change indication and said generation of deactivation voltage/current.

If a delay is realized access change may be limited to data stored after reception of the access change indication and prior to said access change.

If said storage unit comprises a flash memory cell with a charging pump, said deactivation voltage and/or said deactivation current may be used for activation of an anti-fuse for disabling the charging pump.

Said charging pump may comprise at least one pass transistor with source and drain connected to the anti-fuse in such way that they are short circuited after activation of the anti-fuse.

If said storage unit comprises a ferroelectric random access memory cell with non-destructive read-out and means for generating an electrical field for programming the ferroelectric random access memory cell, said deactivation voltage and/or said deactivation current may be used for disabling the means for generating the electrical field.

And if said storage unit comprises a magneto-resistive random access memory cell and means for generating a current for programming the magneto-resistive random access memory cell, said deactivation voltage and/or said deactivation current may be used for limiting the current which can be generated by said means for generating the current.

The storage device may be adapted such that already stored data is undeletable after reception of said access change indication.

For instance, access is changed to read-only after reception of said access change indication.

The invention further proposes a method for using a non-volatile storage device according to claim 10. Said method comprises allowing for altering of data stored in the storage device, receiving an access change indication, and inhibiting altering of data stored in the storage device after reception of said access change indication.

In an embodiment of said method, inhibiting altering comprises disabling, in response to said access change indication, a charging pump of a flash memory cell comprised in a storage unit of said storage device.

Disabling the charging pump may comprise short-circuiting source and drain of at least one pass transistor comprised in said charging pump.

And short-circuiting may comprise activating an anti-fuse connected to said source and drain.

### Drawings

Exemplary embodiments of the invention are illustrated in the drawings and are explained in more detail in the following description.

In the figures:
- Fig. 1: depicts an exemplary block diagram of a prior art storage unit based on flash,
- Fig. 2: depicts an exemplary block diagram of an exemplary storage device in accordance with the invention and
- Fig. 3: depicts an exemplary flow diagram of an exemplary embodiment of the invention.

### Exemplary embodiments

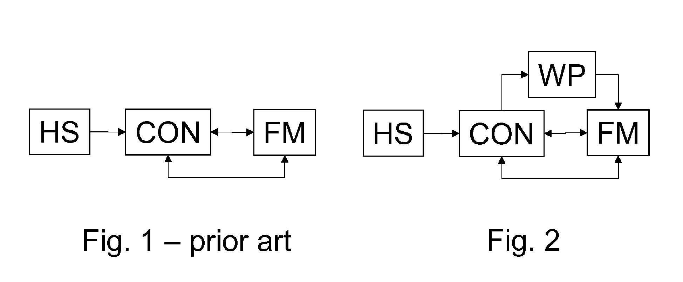

As depicted in fig. 1, exemplary prior art storage units based on flash memories comprise one or more flash modules FM and a controller CON which acts as an interface interacting with a hosting system HS which may be a consumer electronic device, a traffic sensor, a personal computer or any other hosting system HS.

Although not depicted in fig. 1, exemplary non-volatile flash memories FM comprise at least one charge pump. The charge pump is used to get the higher voltage required for programming and erasing. The charge pump is provided for the convenience of single power supply operation. There may be a separate charging pump for each flash module FM or for groups of flash modules FM.

Fig. 2 shows how the proposed invention may enrich the prior art system of fig. 1 by a module WP which serves for write protection. Block WP is in charge of achieving persistent storage functionality. Prior to activation of module WP, the storage unit may be utilized for storing of data as well as any manipulation of stored data such as altering and erasure.

The module WP may be activated by a user at his/her own choice. Or, a triggering event may activate write protection WP. For instance, a crash sensor may trigger permanent storage of car or airplane data in a data logger. Prior to such trigger, data logged in the device may be overwritten in fixed time cycle.

The content of the storage unit may be controlled via the host HS. When the device is selected for permanent storage the host sends the adequate command and the memory controller activates the write protection WP for the flash modules FM.

After reception of the user or event generated trigger, module WP either immediately acts on the memory module FM such that accessibility is changed, or initiates a time counter wherein access to memory module FM is changed after a delay has elapsed. The module WP may receive the delay as a further input or use a predetermined delay.

If access change occurs delayed, module WP may already act on the flash modules FM immediately after reception of the trigger such that what is stored after the trigger and before elapse of the delay is stored in a subset of the available memory cells. Then, access change may be limited to said subset wherein access to other memory cells of the storage unit remains such that writing, erasing and/or amendment of data is allowed.

The actual access change may be achieved by manipulation of one or more charging pumps. One possibility, besides many others, to put one charge pump out of action is to short-circuit the source and the drain of a pass transistor comprised in the one charging pump. Then, the deactivated or short-circuited charging pump will no longer be able to produce said high programming voltage required for erasing or programming that non-volatile memory which is connected to the deactivated charging pump.

Thus, for what is stored in memory cells connected to the deactivated charging pump is stored forgery-proof and persistently.

Short-circuiting may be achieved by an anti-fuse connecting said source and drain, for instance. Then, write controlling block WP generates a programming or deactivation voltage which makes the anti-fuse permanently conductive and thus short-circuiting the pass transistor.

There are many other mechanisms applicable for changing access such that cells of the non-volatile storage device are prevented from being programmed. For example, the programming current might be interrupted by a dedicated heating element, by a piezo element or by a micro-electromechanical system (MEMS). In contrast to the direct reaction of an applied high switching current, the heat element destroys a segment of the conductor connecting the programming circuit with the power source indirectly. In addition or alternatively to the mechanisms forced by voltage or current, prevention of storage cells from further programming may be achieved by mechanical switches. E.g., piezo elements may be deployed in order to tear apart the conductor supplying the programming circuit with power. Or a specially designed micro-electromechanical system (MEMS) - like the mechanism of ballpoint for instance - may be used to switch the programming power finally off. In all cases the package of the non-volatile storage device has to be mechanically destroyed in order to manipulate the stored values afterwards.

In another embodiment the deactivation of the write and erase functionality may be achieved without additional circuit technology in the memory device by using existing programming functionality.

Other non-volatile memory like phase-change memory (PRAM) or Magnetic Resistive RAM (MRAM) use current for writing. For instance, in PRAM the writing current is used for heating up a ceramic alloy of chalcogenide material. A bit is represented by different phases of the chalcogenide material: Resistive amorphous state (reset state) or a crystalline state (set state). Current drivers are used to generate the adequate write-current.

Similarly, MRAM use the writing current for inducing a magnetic field in one plate of a pair of ferro-magnetic plates separated by an insulating layer wherein the other plate of said pair is a permanent magnet.

Thus, the principles of the proposed inventions may be realized for PRAM or MRAM in that a write-current driver is prevented from generating the current required for writing to the PRAM or MRAM. For instance, an anti-fuse may be used to limit an output current of the current-driver to a level insufficient for phase-change. Or, one of the other mechanisms mentioned above may be used for limitation of the output current.

The proposed invention is applicable for Ferroelectric RAM (FeRAM or FRAM), also, if optical addressing is used for non-destructive read-out (NDRO). For writing to FeRAM with NDRO an electrical field is induced across a ferroelectric layer comprised in a cell resulting in a polarization of said layer. A driver used for generating the electrical field can be disabled or bypassed for instance by an anti-fuse in a way similar to the way the charge pump of a Flash is disabled. Or, one of the other mechanisms mentioned above may be used.

The proposed method for a forgery-proof write protected storage by permanent deactivating the write and erase functionalities may further be utilized in Solid State Disks (SSD). When the SSD is selected for persistent storage the host sends the adequate command and the SSD controller activates the write protection for all or some flash modules.

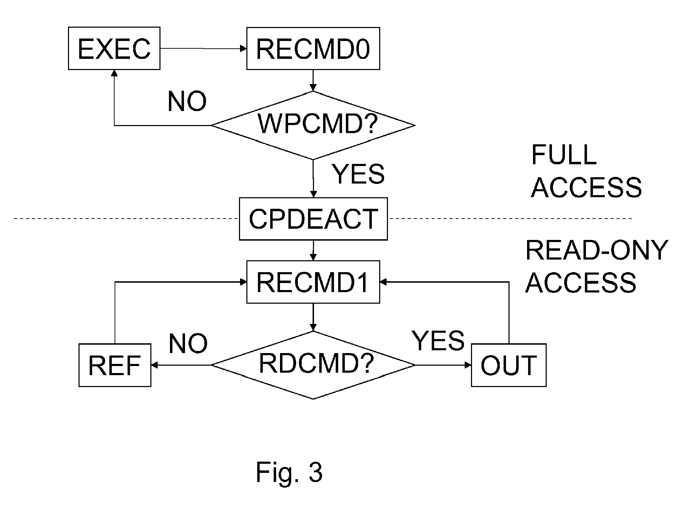

Fig. 3 exemplarily depicts a state diagram of the controller CON according to an embodiment of the invention. While being in full access mode, the controller CON in a state RECMD0 for receiving commands from host HS. Then, it is determined in state WPCMD? whether the received command is a write protect command. If the answer is "NO", the controller CON enters executing state EXEC and executes the command. After execution, the controller CON returns to command reception state RECMD0. If the answer is "YES", the controller CON enters charge pump deactivation state CPDEACT and instructs module WP for making write access, amend access, alter access and erase access impossible by impairment of a writing current or writing voltage generating device, e.g. the current driver or the charging pump.

After impairment of the writing current or writing voltage generating device, the memory FM is in a read-only access mode and the controller is in a modified state for receiving commands RECMD1. Upon reception of a command the controller checks in state RDCMD? whether the received command is a read command. If the answer is "NO", the command is refused in state REF and the controller returns to RECMD1. If, the answer is "YES", the requested read out is performed and the controller CON outputs the read-out data in state OUT before returning to state RECMD1.

Devices according the present invention allow to record data in a forgery-proof and write protected manner, for instance during negotiations, interrogations, contract proceedings, medical items, etc. Devices are able to operate as common versatile storage unit, but can be switched into irreversibly forgery-proof mode if desired.

## Claims

1. Non-volatile storage device comprising a storage unit, means for receiving an access change indication and means for changing access to said storage unit in response to said access change indication wherein access prior to reception of said access change indication is such that data can be stored in said storage unit and already stored data can be altered and access after change of access is such that said at least some of already stored data is unalterable.

2. Storage device according to claim 1, wherein said storage device further comprises means for write controlling which generate a deactivation voltage and/or a deactivation current in response to said access change indication.

3. Storage device according to claim 2, wherein a delay is realized between reception of said access change indication and said generation of said deactivation voltage and/or said deactivation current wherein access change is limited to data stored after reception of the access change indication and prior to said access change.

4. Storage device according to claim 2 or 3, wherein said storage unit comprises a flash memory cell with a charging pump and said deactivation voltage and/or said deactivation current is used for activation of an anti-fuse for disabling the charging pump.

5. Storage device according to claim 4, wherein said charging pump comprises at least one pass transistor with source and drain connected to the anti-fuse in such way that they are short circuited after activation of the anti-fuse.

6. Storage device according to claim 2 or 3, wherein said storage unit comprises a ferroelectric random access memory cell with non-destructive read-out and means for generating an electrical field for programming the ferroelectric random access memory cell and said deactivation voltage and/or said deactivation current is used for disabling the means for generating the electrical field.

7. Storage device according to claim 2 or 3, wherein said storage unit comprises a magneto-resistive random access memory cell and means for generating a current for programming the magneto-resistive random access memory cell and said deactivation voltage and/or said deactivation current is used for limiting the current which can be generated by said means for generating the current.

8. Storage device according to one of the preceding claims, wherein said already stored data is undeletable after reception of said access change indication.

9. Storage device according to one of the preceding claims, wherein access is changed to read-only after reception of said access change indication.

10. Method for using a non-volatile storage device, said method comprising
- allowing for altering of data stored in the storage device,
- receiving an access change indication, and
- inhibiting altering of data stored in the storage device after reception of said access change indication.

11. Method according to claim 10, wherein inhibiting altering comprises
- disabling, in response to said access change indication, a charging pump of a flash memory cell comprised in a storage unit of said storage device.

12. Method according to claim 11, wherein disabling the charging pump comprises
- short-circuiting source and drain of at least one pass transistor comprised in said charging pump.

13. Method according to claim 12, wherein short-circuiting comprises activating an anti-fuse connected to said source and drain.
